# EUROPEAN PATENT SPECIFICATION

(11) **EP 3 388 841 B1**
(45) Date of publication and mention of the grant of the patent: **11.12.2019**
(21) Application number: 18176114.9
(22) Date of filing: 09.05.2013
(51) Int. Cl.: G01N 35/08, B01J 19/00, G01N 37/00

(54) **MICROCHIP AND METHOD FOR MANUFACTURING THE SAME**
MIKROCHIP UND VERFAHREN ZUR HERSTELLUNG EINES MIKROCHIPS
MICROPUCE ET SON PROCÉDÉ DE PRODUCTION

(30) Priority: 09.07.2012 JP 2012153584
(43) Date of publication of application: 17.10.2018
(62) Divisional of application: 13817319.0
(73) Proprietor: Sony Corporation, Tokyo 108-0075 (JP)
(72) Inventor: WATANABE, Hidetoshi, Tokyo, 108--0075 (JP); SEGAWA, Yuji, Tokyo, 108-0075 (JP); KATO, Yoshiaki, Tokyo, 108-0075 (JP)
(74) Representative: D Young & Co LLP

(56) References cited:
- WO-A1-98/45693
- WO-A1-2008/032128
- WO-A1-2011/099246
- WO-A2-2007/021762

## Description

### Technical Field

The present technology relates to a microchip that includes a plurality of substrate layers. More particularly, the present technology relates to a microchip having a bonding layer provided at a boundary surface between substrate layers.

### Background Art

In recent years, a microchip that is provided with a well or flow channel used to perform chemical and biological analysis on a substrate made of silicon or glass by applying micro-electro-mechanical technology to semiconductor industries has been developed. Such a microchip is beginning to be used, for example, for an electrochemical detector in liquid chromatography or a compact electrochemical sensor in medical fields.

An analysis system using such a microchip is called micro-total-analysis systems (µ-TAS), a lab-on-a-chip or biochip, and the analysis system has received attention as a technique that enables high-speed, high-efficiency, and high-integration chemical and biological analysis or the miniaturization of an analyzer. The µ-TAS allows analysis to be performed with a small quantity of sample and a microchip to be disposed of (disposable), and thus it is particularly expected to be applicable to biological analysis that handles a small quantity of valuable and vulnerable sample or a large number of specimens.

Such a microchip as described above is generally manufactured by bonding a substrate having a well or flow channel molded therein to another substrate. When substrates are bonded, it is necessary to reliably seal a microstructure to which a sample is introduced without damaging a microstructure such as a flow channel provided in the substrate.

For example, Patent Literature 1 discloses "a microchip including an area to which a solution is introduced while maintaining the inner pressure of the area to be negative relative to atmospheric pressure. This microchip is formed by bonding a plurality of substrate layers made of different materials. The microchip composed of such a composite material substrate layer may have insufficient bonding strength between substrate layers. Patent Literature 2 discloses a microchip that includes a substrate structure including a fluid channel configured to contain a sample solution, wherein the fluid channel is maintained at a pressure lower than atmospheric pressure prior to injection of the sample solution into the fluid channel. Patent literature 3 discloses a low temperature process for bonding microfluidic devices, which are composed of at least one plastic substrate, and which is based on the surface modification of the substrates composing the device resulting in the irreversible bonding between the substrates.

### Citation List

### Patent Literature

Patent Literature 1: JP 2011-163984A
Patent Literature 2: WO 2011/099246A1
Patent Literature 3: WO 2008/032128A1

### Summary of Invention

### Technical Problem

In some case, the bonding strength between substrate layers may be insufficient depending on combination of materials of a substrate layer that constitutes a microchip. Thus, a primary objective of the present technology is to provide technology for enhancing the bonding strength between substrate layers.

### Solution to Problem

To solve the problems, the present technology provides a microchip including a plurality of substrate layers, and bonding layers provided at boundary surfaces between the substrate layers and configured to include a silicon compound. At least one of the bonding layers includes an organic silicon compound, wherein the plurality of substrate layers include a first substrate layer having an opening formed therein to allow a portion of a puncture member to penetrate into the microchip, a second substrate layer comprising a groove on a surface bonded to a third substrate layer, thereby forming a sealed area.

The plurality of substrate layers may include a substrate layer made of non-silicone resin and a substrate layer made of polydimethylsiloxane. Both surfaces of the substrate layer made of polydimethylsiloxane may be bonded to a first substrate layer made of non-silicone resin and a second substrate layer made of non-silicone resin through the bonding layer.

The first substrate layer made of non-silicone resin may a groove on a bonding surface bonded to the substrate layer made of polydimethylsiloxane. The second substrate layer made of non-silicone resin and the substrate layer made of polydimethylsiloxane may be bonded through the bonding layer made of an organic silicon compound, the second substrate layer made of non-silicone resin has no groove on a bonding surface bonded to the substrate layer made of polydimethylsiloxane.

Further, the substrate layer made of polydimethylsiloxane may be bonded to the first substrate layer made of non-silicone resin through a bonding layer made of an inorganic silicon compound.

In addition, the substrate layer made of polydimethylsiloxane may have a groove on a bonding surface bonded to the first substrate layer made of non-silicone resin. The first substrate layer made of non-silicone resin and the second substrate layer made of non-silicone resin may have each bonded to the substrate layer made of polydimethylsiloxane through the bonding layer made of an organic silicon compound.

The first substrate layer made of non-silicone resin and the second substrate layer made of non-silicone resin may be composed of acrylic resin or polycarbonate, and may be impermeable to gas.

Further, the substrate layer made of polydimethylsiloxane may have a self-sealing ability due to elastic deformation. The groove may have an inner space which is negative pressure relative to atmospheric pressure.

The present technology provides a method for manufacturing a microchip, the method comprising a deposition process of coating a groove forming surface of a first substrate layer made of non-silicone resin with a cross-linkable composition containing a silicon compound, the groove forming surface of the first substrate layer being provided with a groove, and a coating process of coating a surface of a second substrate layer made of non-silicone resin with a cross-linkable composition containing an organic silicon compound, the surface of the second substrate layer being provided with no groove.

The method for manufacturing a microchip according to claim 9, the method may include a bonding process of bonding each of the groove forming surface of the first substrate layer made of non-silicone resin and the surface of the second substrate layer made of non-silicone resin to a substrate layer made of polydimethylsiloxane, the groove forming surface of the first substrate layer being coated with the cross-linkable composition containing a silicon compound, the surface of the second substrate layer being coated with the cross-linkable composition containing an organic silicon compound and provided with no groove.

### Advantageous Effects of Invention

According to the present technology, there is provided a microchip having enhanced bonding strength between substrate layers.

### Brief Description of Drawings

[FIG. 1] FIGS. 1A and 1B are schematic diagrams for describing the configuration of a microchip 1a according to a first embodiment of the present technology.
[FIG. 2] FIG. 2 is a flowchart for describing a method for manufacturing the microchip 1a.
[FIG. 3] FIGS. 3A to 3F are schematic diagrams for describing a method for manufacturing the microchip 1a.
[FIG. 4] FIG. 4 is a schematic diagram for describing the configuration of a microchip 1b according to a second embodiment of the present technology.
[FIG. 5] FIG. 5 is a flowchart for describing a method for manufacturing the microchip 1b.
[FIG. 6] FIG. 6A to 6F are schematic diagrams for describing a method for manufacturing the microchip 1b.
[FIG. 7] FIG. 7 is a schematic diagram for describing the configuration of a microchip 1c according to a third embodiment of the present technology.
[FIG. 8] FIG. 8A to 8F are schematic diagrams for describing a method for manufacturing the microchip 1c.

### Description of Embodiments

Hereinafter, preferred embodiments for carrying out the present technology will be described. Note that, embodiments described below are intended only to illustrate an exemplary embodiment of the present technology and the scope of the present technology is not construed as being limited to the described embodiments. The description will be given in the following order.
1. Configuration of Microchip according to First Embodiment of Present Technology
2. Method for Manufacturing Microchip according to First Embodiment of Present Technology
   (1) Molding of Substrate Layer
   (2) Lamination of Cross-linkable Composition
   (3) Curing of Cross-linkable Composition
   (4) Bonding of Substrate Layer
3. Configuration of Microchip according to Second Embodiment of Present Technology
4. Method for Manufacturing Microchip according to Second Embodiment of Present Technology
   (1) Coating of Cross-linkable Composition
5. Configuration of Microchip according to Third Embodiment of Present Technology
6. Method for Manufacturing Microchip according to Third Embodiment of Present Technology
   (1) Molding of Substrate Layer
   (2) Coating of Cross-linkable Composition

### 1. Configuration of Microchip according to First Embodiment of Present Technology

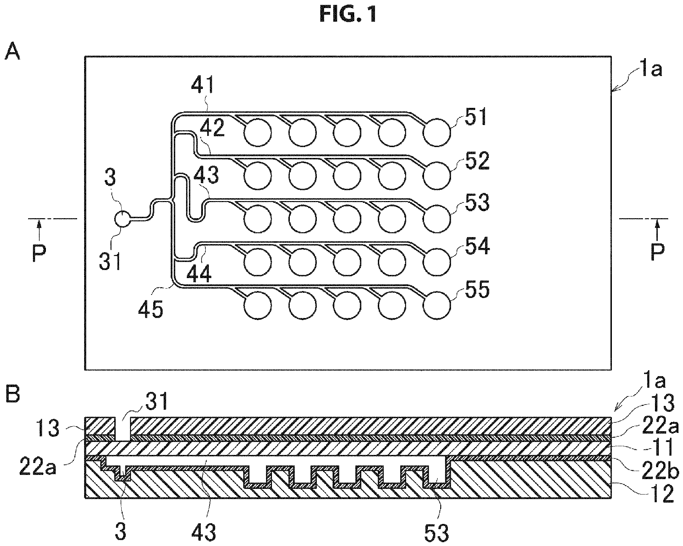

FIG. 1 is a schematic diagram illustrating the configuration of a microchip 1a according to a first embodiment of the present technology. FIG. 1A is a schematic top view, and FIG. 1B is a schematic cross-sectional view corresponding to a section taken along the line P-P of FIG. 1A.

A microchip indicated by reference numeral 1a in the figure is provided with an entry portion 3, wells 51 to 55, and flow channels 41 to 45. The entry portion 3 acts as an area for introducing liquid such as a sample solution and allows liquid to be introduced from the outside. The wells 51 to 55 are used as reaction fields of an object to be analyzed. The flow channels 41 to 45 are used to connect the entry portion 3 with each of the wells 51 to 55. In FIG. 1 and the description thereof, the description is based on the assumption that five wells supplied with liquid through the flow channel 41 are all regarded as the well 51, and similarly, five wells supplied with liquid through the flow channels 42, 43, 44, and 45 are regarded as the wells 52, 53, 54, and 55, respectively. The configuration of the microchip according to the present technology is not limited to the number and arrangement of the entry portion 3, the flow channels 41 to 45, and the wells 51 to 55 as illustrated in FIG. 1.

The microchip according to the present technology is configured to include a plurality of substrate layers and a bonding layer. The bonding layer is made of a silicon compound provided at a boundary surface between substrate layers. In addition, at least one of the bonding layers is made of organic silicon compounds. The microchip 1a according to the present embodiment illustrated in FIG. 1B is configured to include, for example, three substrate layers 11, 12, and 13. A plurality of substrate layers 11, 12, and 13 constituting the microchip 1a preferably include a substrate layer made of non-silicone resin and a substrate layer made of polydimethylsiloxane. In addition, two surfaces of the substrate layer made of polydimethylsiloxane are bonded to a first substrate layer made of non-silicone resin and a second substrate layer made of non-silicone resin through the bonding layer. In the microchip 1a according to the present embodiment, for convenience of description, the substrate layer made of polydimethylsiloxane is referred to as substrate layer 11, "the first substrate layer made of non-silicone resin" of the two substrate layers to be bonded to the substrate layer 11 is referred to as "substrate layer 12", and "the second substrate layer made of non-silicone resin" of the two substrate layers to be bonded to the substrate layer 11 is referred to as "substrate layer 13". This is similarly applicable to second and third embodiments described later.

In the microchip 1a, the substrate layer 12 has a groove on a surface bonded to the substrate layer 11. The groove corresponds to an area for introducing liquid such as a sample solution, and this area includes the entry portion 3, the flow channels 41 to 45, and the wells 51 to 55. The substrate layer 12 is bonded to the substrate layer 11 through a bonding layer 22b that is made of a silicon compound. The bonding layer 22b is a bonding layer made of an inorganic silicon compound. On the other hand, the substrate layer 13 does not have any groove on a surface bonded to the substrate layer 11, and the substrate layer 13 is bonded to the substrate layer 11 through a bonding layer 22a that is made of organic silicon compounds.

In the microchip 1a, the substrate layer 12 has a groove provided on a surface bonded to the substrate layer 11, and thus an area for introducing liquid such as the entry portion 3 provided in the microchip 1a is not in communication with the outside of the microchip 1a. If the substrate layer 11 is made of a material having elasticity, it is possible to allow a portion of a puncture member such as a needle to penetrate from the outside of the microchip 1a to the entry portion 3 through an inlet 31 formed in the substrate layer 13. If a needle connected to a syringe previously filled with liquid penetrates to the substrate layer 11, it is possible to introduce liquid to an area such as the entry portion 3 in the microchip 1a. Furthermore, the sealed area is connected to only the inner part of the syringe even if a needle or the like penetrates to the substrate layer, and thus an air bubble is prohibited from entering the flow channels 41 to 45 or the wells 51 to 55 and the introduction of liquid is possible.

After the introduction of liquid, when a needle or the like is extracted from the entry portion 3, if the substrate layer 11 is made of a material having elasticity, the self-sealing ability of the substrate layer 11 allows a punctured portion to be sealed spontaneously. In the present technology, the spontaneous sealing of a punctured portion caused by a needle or the like due to elastic deformation of a substrate layer is defined as "self-sealing ability" of a substrate layer.

The liquid to be introduced into the microchip 1a refers to a sample solution or the like that includes an object to be analyzed and a substance used to produce an object to be analyzed by making it react with another substance. Examples of an object to be analyzed can include proteins such as nucleic acids, for example, DNA or RNA, peptides, and antibodies. A biological sample including the object to be analyzed described above, such as blood, or a diluted solution thereof can also be employed as liquid to be introduced into the microchip 1a. In addition, an analysis method using the microchip 1a includes, for example, an analysis method using nucleic acid amplification reaction such as the known polymerase chain reaction (PCR) technique that carries out thermal cycling and a various isothermal amplification techniques without using thermal cycling.

### 2. Method for Manufacturing Microchip according to First Embodiment of Present Technology

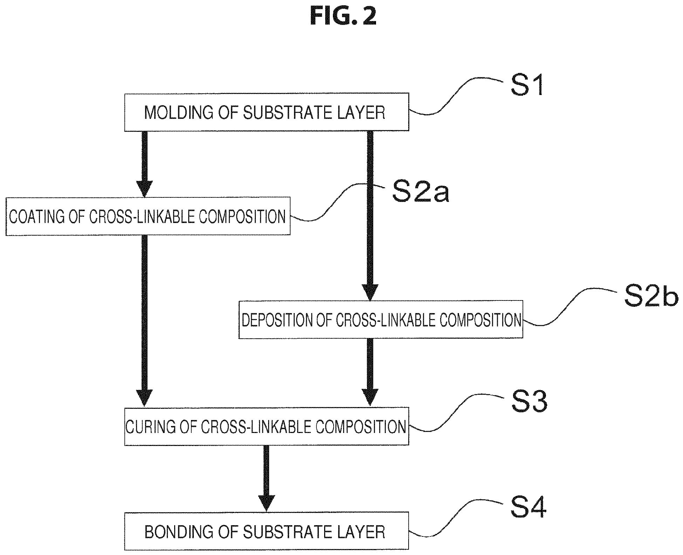

A method for manufacturing the microchip 1a is described with reference to the flowchart illustrated in FIG. 2.

### (1) Molding of Substrate Layer

The reference numeral S1 in FIG. 2 indicates a substrate layer molding process. In this process, grooves corresponding to the entry portion 3, the flow channels 41 to 45, and the wells 51 to 55 are formed on the substrate layer 12, and an opening corresponding to the inlet 31 is formed on the substrate layer 13. The substrate layers 12 and 13 may employ glass, plastics, metals and ceramics as its material, and plastics are particularly preferred. In addition, as described later, the substrate layers 12 and 13 preferably employ a material that is impermeable to gas. Examples of a plastic material having gas impermeability include polymethylmethacrylate (PMMA: acrylic resin), polycarbonate (PC), polystyrene (PS), polypropylene (PP), polyethylene (PE), polyethylene terephthalate (PET), diethylene glycol-bis-allyl carbonate, styrene-acrylonitrile copolymer (SAN resin), MMA-styrene copolymer (MS resin), TPX (poly(4-methyl-1-pentene)), polyolefin, SiMA (siloxanyl methacrylate monomer)-MMA copolymer, SiMA-fluorine containing monomer copolymer, silicone macromer-(A)-HFBuMA (heptafluorobutyl methacrylate)-MMA terpolymer, and disubstituted polyacetylene-based polymer. Among them, an acrylic resin or PC that is non-silicone resin is particularly suitable.

In a case where the substance retained in each of the wells 51 to 55 of the microchip 1a is optically analyzed, it is desirable to select a material having optical transparency, less auto-fluorescence, and less optical error due to a small wavelength distribution as a material of the substrate layers 11, 12, and 13.

The entry portion 3 or the like can be molded in the substrate layers 12 and 13 by using a known technique. For example, the molding is performed through wet etching or dry etching of a substrate layer made of glass, or alternatively nano-imprinting, injection molding or cutting of a substrate layer made of plastic. In addition, the microchip 1a is not limited to the configuration illustrated in FIG. 1, but it is possible to mold an area such as the entry portion 3 for introducing liquid in the substrate layer 11, or alternatively, a portion of the area may be molded in the substrate layer 11 and the rest of the area may be formed in the substrate layer 12.

In the method for manufacturing the microchip 1a illustrated in FIG. 2, the substrate layer molding process S1 is not an essential process, another substrate layers 12 and 13 having a groove or opening molded previously therein are prepared separately, and the process can start from a process S2 of laminating the substrate layers 12 and 13 with a cross-linkable composition, which will be described later.

### (2) Lamination of Cross-linkable Composition

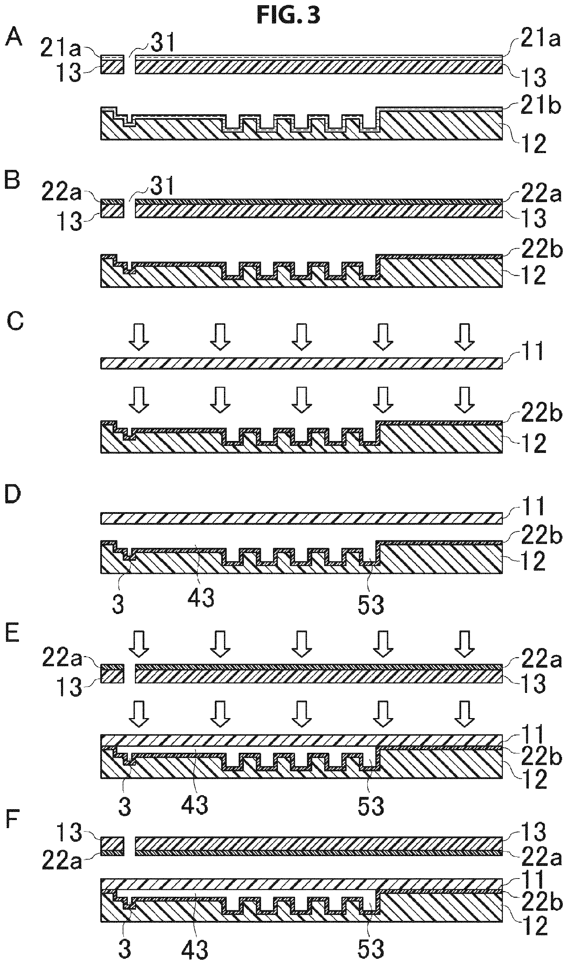

In FIG. 2, the reference numeral S2 (S2a and S2b) indicates a process of laminating a cross-linkable composition onto the substrate layers 12 and 13. In addition, FIG. 3 is a schematic diagram illustrating each step from this process to a substrate layer bonding process S4. As illustrated in FIG. 3A, in this process, a cross-linkable composition 21b containing a silicon compound is laminated onto the substrate layer 12, and a cross-linkable composition 21a containing a silicon compound is laminated onto the substrate layer 13. More specifically, the substrate layer 13, which is formed with only an opening corresponding to the inlet 31, has a surface on which a groove is not provided, and the surface is coated with the cross-linkable composition 21a containing organic silicon compounds (cross-linkable composition coating process S2a). The substrate layer 12 has a groove forming surface on which a groove corresponding to the entry portion 3 or the like is formed, and the cross-linkable composition 21b containing a silicon compound is deposited on the groove forming surface (cross-linkable composition deposition process S2b).

### [Cross-linkable Composition Coating Process S2a]

The cross-linkable composition containing silicon compounds, which is used in the process of manufacturing the microchip 1a, is, for example, a condensate that contains a silanol group produced by the hydrolysis and partial condensation of alkoxysilanes, and it may be in the state where the condensate is dispersed in liquid such as an alcohol solvent. The cross-linkable composition 21a to be used in the coating process S2a preferably contains organic silicon compounds. The cross-linkable compositions containing organic silicon compounds are, for example, those in which the condensate of alkoxysilane containing organic functional groups is added to a solvent in which the condensate containing the silanol group described above is dispersed. More specifically, for example, it may be a solvent or the like in which a condensate of alkyltrialkoxysilane and tetraalkoxysilane is contained. Moreover, in addition to the condensate described above, colloidal silica or the like may be added to the cross-linkable composition containing organic silicon compounds.

The cross-linkable composition 21a containing organic silicon compounds used in this process may be available silicone hard coating agents or the like. As the substrate layer 13 made of PC, for example, a hard coating agent "NSC-1600" manufactured by NIPPON FINE CHEMICAL Co., Ltd. can be used. In addition, as the substrate layer 13 made of PMMA, for example, a hard coating agent "NSC-2705" manufactured by NIPPON FINE CHEMICAL Co., Ltd. can be used.

The coating of the substrate layer 13 with the cross-linkable composition 21a containing organic silicon compounds can be performed using a known technique that includes, for example, dip coating, spray coating, flow coating, and spin coating. When a coating technique in which organic chains contained in the cross-linkable composition 21a are retained is used, the coating method is not particularly limited as long as a technique suitable for the property or shape of the material of the substrate layer 13 is selected.

### [Cross-linkable Composition Deposition Process S2b]

On the other hand, the cross-linkable composition 21b used in the deposition process S2b contains silicon compounds, but it is not limited to a condensate containing organic silicon compounds, and a condensate containing silicon compounds that does not contain organic chains may be used. In the present embodiment, the silicon compounds that do not contain organic chains are referred to as "inorganic silicon compounds". The cross-linkable composition 21b includes, for example, a solution that contains a condensate of alkoxysilanes such as polysiloxane oligomer.

The deposition of the cross-linkable composition 21b containing inorganic silicon compounds on the substrate layer 21b can be performed using a known technique that includes, for example, vacuum deposition, ion plating, and sputtering. From among these techniques, the deposition method is not particularly limited as long as a technique suitable for the property, shape, or the like of the material of the substrate layer 13 is selected.

In the process of manufacturing the microchip 1a illustrated in FIG. 3, only the surfaces of the substrate layers 12 and 13, which are each in contact with the substrate layer 11, are coated or deposited with the cross-linkable compositions 21a and 21b, but other portions of each of the substrate layers 12 and 13 may be coated or deposited with the cross-linkable compositions 21a and 21b. In the microchip 1a according to the first embodiment of the present technology, the necessity of the coating or deposition of the cross-linkable composition 21a or 21b to regions other than the surfaces of the substrate layers 12 and 13 bonded to the substrate layer 11 is not particularly limited. In addition, this is also true for a microchip 1b according to a second embodiment and a microchip 1c according to a third embodiment, as described later.

For example, the selection of dip coating as a technique for coating the substrate layer 13 with the cross-linkable composition 21a makes it possible to coat all surfaces constituting the substrate layer 13 simultaneously. When the cross-linkable composition 21a or 21b is coated to or deposited on an outer surface of the microchip 1a, the cross-linkable composition 21a or 21b is cured by a curing process of the cross-linkable composition 21a or 21b described later, and then the outer surface of the microchip 1a is coated with a layer formed by curing the cross-linkable composition 21a or 21b. The outer surface of the microchip 1a that is coated with the layer is hardly damaged and thus the microchip 1a has improved durability.

### (3) Curing of Cross-linkable Composition

In FIG. 2, reference numeral S3 indicates a process of polymerizing and curing a cross-linkable composition. In this process, as illustrated in FIGS 3A and 3B, the cross-linkable compositions 21b and 21a laminated on the substrate layers 12 and 13 are heated and cured. In other words, this process is a process of forming bonding layers 22a and 22b by polymerizing the cross-linkable compositions 21a and 21b, respectively. The silanol group contained in the cross-linkable compositions 21a and 21b are heated and condensed to form a siloxane bond (Si-O-Si). The cross-linkable compositions 21a and 21b containing the siloxane bond are cured, thus the resulting layers are the bonding layers 22a and 22b.

The cross-linkable composition 21a is heated in a state where it coats the substrate layer 13 and the cross-linkable composition 21b is heated in a state where it coats the substrate layer 12, thus the heating temperature may be determined depending on the material of the substrate layers 12 and 13. The heating temperature is, for example, preferably 80 to 120°C in a case where PC is used in the substrate layers 12 and 13, and is preferably 60 to 80°C in a case where PMMA is used.

### (4) Bonding of Substrate Layer

In FIG. 2, reference numeral S4 is a substrate layer bonding process. This process is a process of bonding the groove forming surface of the substrate layer 12 coated with the cross-linkable composition 21b containing silicon compounds (the surface having the area formed thereon) and the surface of the substrate layer 13 which has no groove and is coated with the cross-linkable composition 21a containing organic silicon compounds to the substrate layer 11. More specifically, for example, the substrate layer 12 is bonded to the substrate layer 11 and then the substrate layer 11 and the substrate layer 13 are bonded to each other. The order of bonding between substrate layers 11, 12, and 13 may begin from the bonding process between the substrate layers 11 and 13.

The bonding layers 22b and 22a laminated on the substrate layers 12 and 13 contain a siloxane bond, and thus the substrate layer 11 is preferably formed of a material made of silicone resin that can form a siloxane bond with the bonding layers 22a and 22b. Furthermore, the substrate layer 11 is preferably composed of silicone-based elastomer having elasticity, and for example, polydimethylsiloxane (PDMS) is desirable. In addition, in the microchip 1a according to the present embodiment, a plurality of substrate layers constituting the microchip preferably include the substrate layers 12 and 13 that are substrate layers made of non-silicone resin described above and the substrate layer 11 that is a substrate layer made of PDMS, and two surfaces of the substrate layer made of PDMS are preferably bonded to the substrate layers made of non-silicone resin (substrate layers 12 and 13) through the respective bonding layers 22b and 22a. This preferred arrangement is similarly applied to the second and third embodiments described later.

As illustrated in FIG. 3C, in bonding the substrate layer 11 to the substrate layer 12, an activation process is performed on the surface of the substrate layer 12 on which the bonding layer 22b is provided and on one surface of the substrate layer 11. The activation process may be performed by irradiating it with oxygen plasma or ultraviolet rays, and other known techniques such as ion beam irradiation may be used. The activation process allows a bond of an OH group to be produced on the surface of the bonding layer 22b on the substrate layer 12. Similarly, when the substrate layer 11 is made of silicone resin, a bond of an OH group is produced on the surface that is subjected to the activation process. The bond of an OH group produced on the substrate layer 11 and the bonding layer 22b has high reactivity, and if their processed surfaces are bonded to each other, a siloxane bond occurs and they are strongly bonded (FIG. 3D). As a result, the substrate layer 11 is bonded to the substrate layer 12 through the bonding layer 22b made of inorganic silicon compounds. In addition, the inner space of the groove formed in the substrate layer 12 is sealed hermetically.

In the manufacture of the microchip 1a, when the bonding between the substrate layers 11 and 12 is performed under negative pressure relative to atmospheric pressure, the inner space of the groove provided in the substrate layer 12 that corresponds to an area such as the entry portion 3 can be sealed hermetically to be negative pressure (1/100 atmospheric pressure) relative to atmospheric pressure. The area in the microchip to which liquid is introduced is at negative pressure relative to atmospheric pressure, and thus the liquid is sucked automatically by negative pressure in the microchip 1a upon introduction of the liquid and the introduction of liquid into the microchip 1a having a fine flow channel structure formed therein can be performed in a shorter period of time.

Moreover, in order to keep the negative pressure in the microchip 1a as described above, materials of the substrate layers 12 and 13 are preferably impermeable to gas. The use of a material such as PC having have gas impermeability in manufacturing the substrate layers 12 and 13 that constitute the outer surface of the microchip 1a allows the area such as the entry portion 3 to be maintained at negative pressure even when the microchip 1a is stored under atmospheric pressure. Furthermore, when the substrate layers 12 and 13 are configured to include a material having gas impermeability, even if the microchip 1a is heated in the procedure of analysis, the liquid introduced into the wells 51 to 55 can be prevented from being vaporized by heating and being lost by penetrating through the substrate layer 11 (a liquid leak).

After the surface between the bonding layer 22a and the substrate layer 11 is subjected to the activation process (FIG. 3E) and an OH group is produced on the processed surface, the bonding between the substrate layers 13 and 11 is similarly performed through the processed surface (FIG. 3F). As a result, the substrate layer 11 is bonded to the surface of the substrate layer 13 in which a groove is not formed through the bonding layer 22a made of organic silicon compounds.

In the microchip 1a according to the first embodiment of the present technology, the bonding layers 22a and 22b containing silicon compounds are provided in the bonding surfaces between the substrate layers 11 and 13 and between the substrate layers 11 and 12, and the substrate layers are bonded to each other through a siloxane bond, and accordingly the substrate layers 11, 12, and 13 can be strongly bonded to each other. Therefore, it is possible to reliably seal the microstructures such as the flow channel formed in the substrate layers.

Furthermore, in the microchip 1a according to the present technology, even if a substrate layer made of glass is not used, a strong bonding state can be achieved by forming a siloxane bond. If a substrate made of glass is not used, the possibility of breakage of the microchip 1a is reduced as compared to the microchip using a substrate layer made of glass. In addition, no use of a substrate layer made of glass makes it possible to obtain weight reduction of the microchip 1a as well.

The bonding layers 22a and 22b of the microchip 1a have advantages of increasing the strength of the microchip 1a itself, in addition to the advantage of strengthening the bonding between the substrate layers 11, 12, and 13. The bonding layers 22b and 22a are held between the substrate layers 11, 12 and 13, and thus the deformation of the microchip 1a is prevented. In particular, at least one bonding layer 22a of the microchip 1a is made of organic silicon compounds, thus it is flexible and cracking is less likely to occur, thereby improving the durability of the microchip 1a, as compared to a bonding layer made of silicon compounds that does not contain organic chains.

### 3. Configuration of Microchip according to Second Embodiment of Present Technology

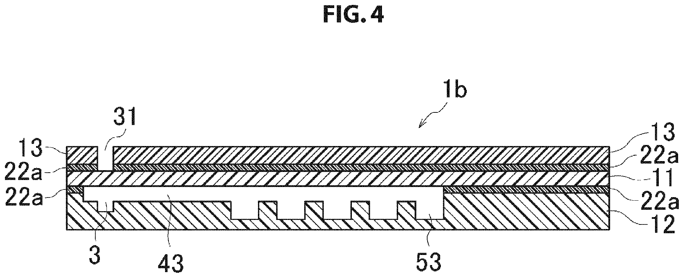

FIG. 4 is a cross-sectional diagram schematically illustrating the configuration of a microchip 1b according to the second embodiment of the present technology. The microchip 1b has the same configuration as the first embodiment except that a bonding layer 22a is provided at the boundary surface between the substrate layer 11 and the substrate layer 12. The configuration that is the same as the first embodiment is denoted with the same reference numerals, and repeated description is omitted. In addition, the materials of the substrate layers 11, 12, and 13 that constitute the microchip 1b are the same as those of the substrate layers of the microchip 1a, which are denoted with the same reference numerals. In the microchip 1b, the bonding layer 22a is provided at the boundary surface between the surface of the substrate layer 12 in which a groove corresponding to the area such as the entry portion 3 is formed and the substrate layer 11, which is the same as the boundary surface between the substrate layer 11 and the substrate layer 13.

### 4. Method for Manufacturing Microchip according to Second Embodiment of Present Technology

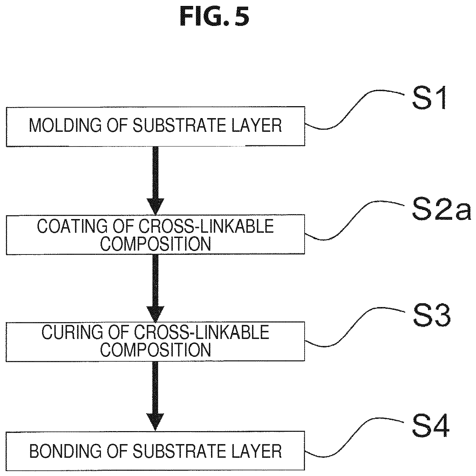

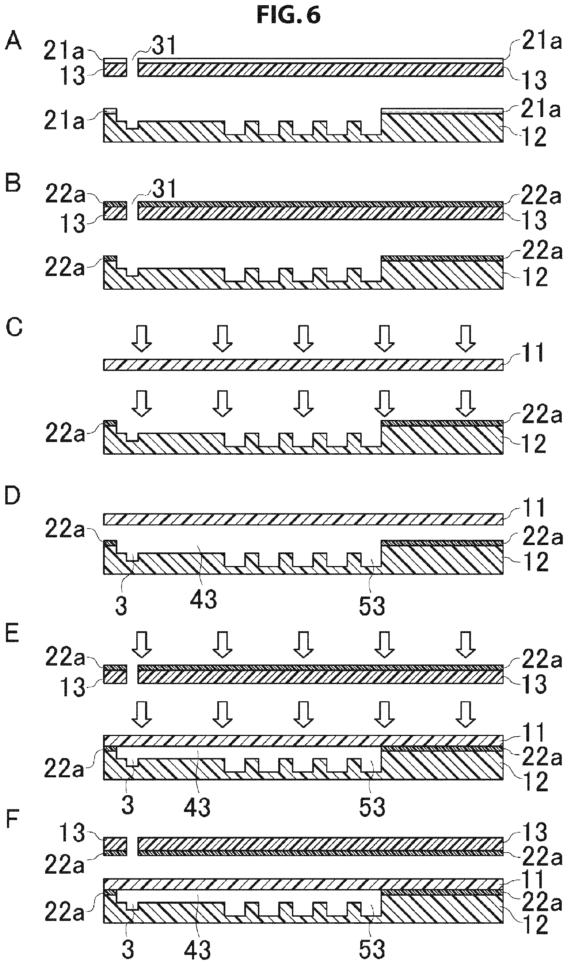

The method for manufacturing the microchip 1b is described with reference to the flowchart shown in FIG. 5. In the process of manufacturing the microchip 1b, the substrate layer molding process S1, the cross-linkable composition curing process S3, and the substrate layer bonding process S4 are similar to the process of manufacturing the microchip 1a according to the first embodiment. Thus, a cross-linkable composition coating process S2a different from that of the process of manufacturing the microchip 1a will be described with reference to FIG. 6.

### (1) Coating of Cross-linkable Composition

In this process, as illustrated in FIG. 6A, a surface of the substrate layer 12 in which a groove corresponding to an area such as the entry portion 3 is formed and one surface of the substrate layer 13 are respectively coated with the cross-linkable composition 21a containing organic silicon compounds. In the present embodiment, each of the cross-linkable compositions 21a that coats the substrate layers 12 and 13 contains organic silicon compounds. The method for coating the substrate layers 12 and 13 with the cross-linkable composition 21a containing organic silicon compounds is similar to that mentioned in the first embodiment. In addition, in the process S2a of coating the substrate layer 12 with the cross-linkable composition 21a, only a portion of the substrate layer 12 that is in contact with the substrate layer 11 is coated.

In order for a portion of the substrate layer 12 to be coated with the cross-linkable composition 21a, a mask may be applied on a portion of the substrate layer 12 that is not to be coated before the coating is applied (a masking layer is not illustrated in FIG. 6A). The application of a mask can use, for example, a water-soluble resist. The portion of the substrate layer 12 in which a well or the like is formed is covered with a water-soluble resist and the substrate layer 12 is coated with the cross-linkable composition 21a. The removal of water-soluble resist from the substrate layer 12 is performed, for example, using water. In order to facilitate the removal of water-soluble resist, techniques such as ultrasound may be used together.

As a mask to be applied, a metal thin film may be used as well. For example, a metal such as aluminum is applied to the substrate layer 12 with a thickness of approximately 100 nm by vapor deposition or sputtering. The removal of a metal thin film from the substrate layer 12 is performed using, for example, an alkaline aqueous solution. The metal thin film is peeled off from the substrate layer 12 using in combination with techniques such as ultrasonic waves, if necessary. In the coating process S2a, a portion to which a mask is applied is not limited to the area such as the entry portion 3 to which a liquid is introduced. For example, when dip coating is selected as the coating method of the cross-linkable composition 21a and one surface of the substrate layer 12 disposed on the outer surface of the microchip 1b is not coated with the cross-linkable composition 21a, the surface of the substrate layer 12 may be masked.

Furthermore, a portion of the substrate layer 12 may be coated with the cross-linkable composition 21a by the precision screen printing or the like without applying a mask to the substrate layer 12.

In the microchip 1b according to the second embodiment, the bonding layer 22a may be formed in the area such as the entry portion 3 to which a liquid is introduced, which is similar to the microchip 1a according to the first embodiment. In the microchip 1b, as long as the effects on a sample solution or analysis using the microchip 1b do not occur, whether or not a grooved portion of the substrate layer 12 is coated with the cross-linkable composition 21a is not particularly limited. In this regard, this is true for the microchip 1a according to the first embodiment and a microchip 1c according to a third embodiment described later.

In FIG. 6A, although the cross-linkable composition containing organic silicon compounds that covers the substrate layer 12 and the cross-linkable composition containing organic silicon compounds that covers the substrate layer 13 are all indicated by the same reference numeral 21a, the composition of the cross-linkable compositions that cover the substrate layers 12 and 13 is not necessarily identical. For example, when the substrate layer 12 is made of PC and the substrate layer 13 is made of PMMA, a cross-linkable composition 21a containing appropriate organic silicon compounds depending on a material of the substrate layers may be selected.

For the substrate layers 12 and 13 subjected to the coating process S2a, similarly to the first embodiment, the cross-linkable composition 21a containing organic silicon compounds is polymerized through the curing process S3 to form the bonding layer 22a (FIG. 6B). Then, in the substrate layer bonding process S4, an activation process is performed on the bonding layer 22a provided on the substrate layer 12 and one surface of the substrate layer 11 made of silicone resin such as polydimethylsiloxane (FIG. 6C), and then the substrate layers 11 and 12 are bonded to each other (FIG. 6D). Similarly, for the substrate layer 13, an activation process is performed on the bonding layer 22a provided on the substrate layer 13 and another surface of the substrate layer 11 (FIG. 6E), and then the substrate layers 11 and 13 are bonded to each other (FIG. 6F).

In the microchip 1b according to the second embodiment of the present technology, similarly to the first embodiment, the bonding layer 22a containing silicon compounds is provided in the bonding surfaces between the substrate layers 11 and 12 and between the substrate layers 11 and 13, and thus the substrate layers 11, 12, and 13 can be strongly bonded. Furthermore, the bonding layers 22a and 22a laminated on the substrate layers 12 and 13 in the microchip 1b all contain organic silicon compounds, and thus the bonding layers are flexible and cracking is less likely to occur, thereby being hardly peeled from the substrate layers 11, 12, and 13 and improving the durability of the microchip 1b, as compared to a bonding layer that does not contain organic chains.

### 5. Configuration of Microchip according to Third Embodiment of Present Technology

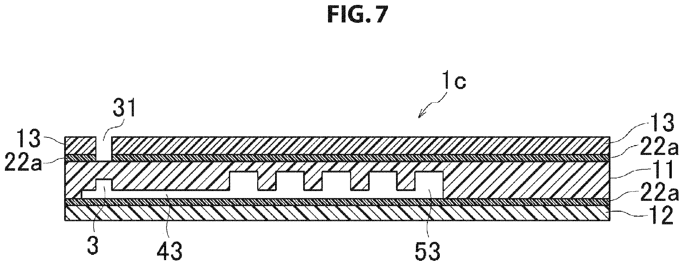

FIG. 7 is a cross-sectional diagram schematically illustrating the configuration of a microchip 1c according to a third embodiment of the present technology. In the microchip 1c, the substrate layer 11 has a groove formed in the surface to be bonded with the substrate layer 12. In addition, the substrate layers 12 and 13 are bonded to the substrate layer 11 through the bonding layer made of organic silicon compounds. In other words, unlike the microchip 1a according to the first embodiment and the microchip 1b according to the second embodiment, in the microchip 1c, an area such as the entry portion 3 to which a liquid is introduced is formed on the substrate layer 11. Other configurations are the same to those of the microchip 1b. The configuration that is the same as the microchip 1b is indicated by the same reference numeral, and repeated description is omitted. In addition, the materials of the substrate layers 11, 12, and 13 that constitute the microchip 1c are the same as those of the substrate layers of the microchip 1a according to the first embodiment, which are indicated by the same reference numerals.

### 6. Method for Manufacturing Microchip according to Third Embodiment of Present Technology

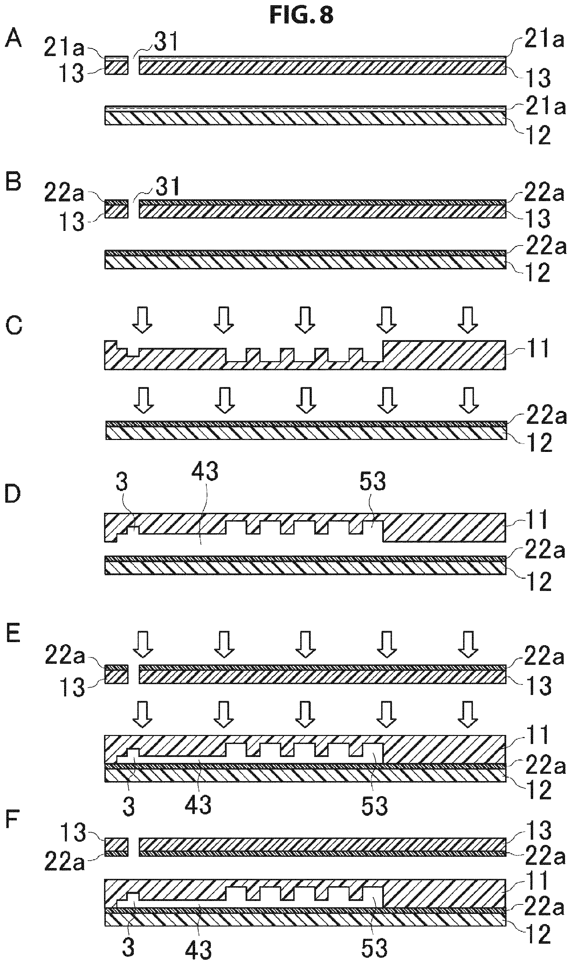

The method for manufacturing the microchip 1c has the manufacturing process procedure that is the same as that of the microchip 1b, and thus the flowchart is omitted. The substrate layer molding process S1 and the cross-linkable composition coating process S2a, which are partially different from the manufacturing process procedure of the microchip 1b, will be described with reference to FIG. 8.

### (1) Molding of Substrate Layer

In the substrate layer molding process S1, a groove that corresponds to an area such as the entry portion 3 is formed in the substrate layer 11 made of silicone resin, for example, polydimethylsiloxane. Thus, as illustrated in FIG. 8A, the substrate layers 12 and 13 have the inlet 31 formed therein, but have no unevenness such as the wells 51 to 55.

### (2) Coating of Cross-linkable Composition

In the cross-linkable composition coating process S2a, one surface of each of the substrate layers 12 and 13 is coated with the cross-linkable composition 21a containing organic silicon compounds (FIG. 8A). In the process of manufacturing the microchip 1c, similarly to the microchip 1b according to the second embodiment, the cross-linkable compositions 21a that cover the substrate layers 12 and 13 contain organic silicon compounds. The method for coating the substrate layers 12 and 13 with the cross-linkable composition 21a containing organic silicon compounds is similar to the technique used in the method for manufacturing the microchip 1a. The composition of the cross-linkable compositions 21a and 21a that cover the substrate layers 12 and 13 is not necessarily identical.

For the substrate layers 12 and 13 coated with the cross-linkable composition 21a containing organic silicon compounds, similarly to the process of manufacturing the microchip 1a, the cross-linkable compositions 21a and 21a containing organic silicon compounds are polymerized through the curing process S3 to form the bonding layers 22a and 22a (FIG. 8B). Then, in substrate layer bonding process S4, an activation process is performed on the bonding layer 22a provided on the substrate layer 12 and the surface of the substrate layer 11 in which a groove is formed (FIG. 8C), and then the substrate layers 11 and 12 are bonded to each other (FIG. 8D). Similarly, for the substrate layer 13, an activation process is performed on the bonding layer 22a provided on the substrate layer 13 and another surface of the substrate layer 11 (FIG. 8E), and then the substrate layers 11 and 13 are bonded to each other (FIG. 8F).

In the microchip 1c according to the third embodiment of the present technology, in the same way as the first and second embodiments, the bonding layer containing silicon compounds is provided at the bonding surfaces between the substrate layers 11 and 12 and between the substrate layers 11 and 13, and thus the substrate layers 11, 12, and 13 can be strongly bonded. In addition, in the same way as the second embodiment, the bonding layers 22a and 22a of the microchip 1c contain organic silicon compounds, and thus the bonding layers are flexible and cracking is less likely to occur. Furthermore, in the process of manufacturing the microchip 1c, the substrate layer 11 made of silicone resin has a groove formed therein, and thus the substrate layers 12 and 13 have flat surfaces to which the bonding layers 22a and 22a are laminated. Thus, the substrate layers 12 and 13 can be easily coated with the cross-linkable composition 21a containing organic silicon compounds without using a technique such as vapor deposition because the silicon compounds contain organic chains.

### Industrial Applicability

In accordance with the microchip of to the present technology, the microstructure in the microchip is hermetically sealed, and thus a small quantity of valuable and vulnerable sample can be reliably analyzed. In addition, a substrate layer made of glass is not used, and thus lightening of the microchip is made possible as well. Therefore, it is easy to carry, and thus the microchip according to the present technology can be used in the determination of genotype, pathogen, or the like in clinical practice.

### Reference Signs List

- 1a, 1b, 1c: microchip
- 11, 12, 13: substrate layer
- 21a, 21b: cross-linkable composition
- 22a, 22b: bonding layer
- 3: entry portion
- 31: inlet
- 41, 42, 43, 44, 45: flow channel
- 51, 52, 53, 54, 55: well

## Claims

1. A microchip (1c) comprising:
a plurality of substrate layers (11,12,13); and
bonding layers (22a) laminated on boundary surfaces between the substrate layers and which include a silicon compound,
wherein at least one of the bonding layers includes an organic silicon compound,
wherein the plurality of substrate layers include an upper substrate layer (13) having an opening formed therein (31) to allow a portion of a puncture member to penetrate into the microchip, a grooved substrate layer (11) having a groove formed on a bonding surface, and a third substrate layer (12) bonded to the bonding surface having the groove, thereby forming a sealed inner space (43,53).

2. The microchip according to claim 1,
wherein the plurality of substrate layers include a substrate layer made of non-silicone resin and a substrate layer made of polydimethylsiloxane, and
wherein both surfaces of the substrate layer made of polydimethylsiloxane are bonded to a first substrate layer made of non-silicone resin and a second substrate layer made of non-silicone resin through the bonding layer.

3. The microchip according to claim 2,
wherein the first substrate layer made of non-silicone resin is the grooved substrate layer and the substrate layer made of polydimethylsiloxane is the third substrate layer,
wherein the second substrate layer made of non-silicone resin and the substrate layer made of polydimethylsiloxane are bonded through the bonding layer made of an organic silicon compound, the second substrate layer made of non-silicone resin has no groove on a bonding surface bonded to the substrate layer made of polydimethylsiloxane.

4. The microchip according to claim 3, wherein the substrate layer made of polydimethylsiloxane is bonded to the first substrate layer made of non-silicone resin through a bonding layer made of an inorganic silicon compound.

5. The microchip according to claim 2,
wherein the substrate layer made of polydimethylsiloxane is the grooved substrate layer and the first substrate layer made of non-silicone resin is the third substrate layer,
wherein the first substrate layer made of non-silicone resin and the second substrate layer made of non-silicone resin are each bonded to the substrate layer made of polydimethylsiloxane through the bonding layer made of an organic silicon compound.

6. The microchip according to claim 4, wherein the first substrate layer made of non-silicone resin and the second substrate layer made of non-silicone resin are composed of acrylic resin or polycarbonate.

7. The microchip according to claim 6, wherein the first substrate layer made of non-silicone resin and the second substrate layer made of non-silicone resin are impermeable to gas.

8. The microchip according to claim 7,
wherein the substrate layer made of polydimethylsiloxane has a self-sealing ability due to elastic deformation,
wherein the sealed inner space is at a negative pressure relative to atmospheric pressure.

9. A method for manufacturing a microchip (1c), the method comprising:
forming a plurality of substrate layers (11,12,13);
laminating a plurality of bonding layers (22a) at boundary surfaces between the substrate layers, wherein the bonding layers include a silicon compound and at least one of the bonding layers includes an organic silicon compound;
forming an upper substrate layer (13) of the plurality of substrate layers to include an opening therein (31) to allow a portion of a puncture member to penetrate into the microchip; and
forming a grooved substrate layer (11) of the plurality of substrate layers with a groove forming surface on which a groove is formed, and
forming a third substrate layer (12) of the plurality of layers to be bonded to the groove forming surface on the grooved substrate layer, thereby forming a sealed area (43,53).

10. The method for manufacturing a microchip according to claim 9, the method comprising:
a deposition process of coating the groove forming surface of the grooved substrate layer made of non-silicone resin with a cross-linkable composition containing a silicon compound; and
a coating process of coating a surface of the upper substrate layer made of non-silicone resin with a cross-linkable composition containing an organic silicon compound, the surface of the upper substrate layer being provided with no groove.

11. The method for manufacturing a microchip according to claim 10, the method comprising:
a bonding process of bonding each of the groove forming surface of the grooved substrate layer made of non-silicone resin and the surface of the upper substrate layer made of non-silicone resin to a third substrate layer made of polydimethylsiloxane, the groove forming surface of the grooved substrate layer being coated with the cross-linkable composition containing a silicon compound, the surface of the upper substrate layer being coated with the cross-linkable composition containing an organic silicon compound and provided with no groove.

## Patentansprüche

1. Mikrochip (1c), umfassend:
eine Vielzahl von Substratschichten (11, 12, 13), und
Bondingschichten (22a), die auf Grenzflächen zwischen den Substratschichten laminiert sind und die eine Siliciumverbindung einschließen;
wobei mindestens eine der Bondingschichten eine organische Siliciumverbindung einschließt,
wobei die Vielzahl der Substratschichten einschließt: eine obere Substratschicht (13) mit einer darin gebildeten Öffnung (31), um zuzulassen, dass ein Anteil eines Durchstechelements in den Mikrochip eindringt,
eine gerillte Substratschicht (11) mit einer auf einer Bondingfläche gebildeten Rille, und eine dritte Substratschicht (12), die an die Bondingfläche mit der Rille gebondet ist, wodurch ein versiegelter innerer Raum (43, 53) gebildet wird.

2. Mikrochip nach Anspruch 1,
wobei die Vielzahl der Substratschichten eine Substratschicht, die aus Nicht-Silikonharz gefertigt ist, und eine aus Polydimethylsiloxan gefertigte Substratschicht einschließt, und
wobei beide Oberflächen der aus Polydimethylsiloxan gefertigten Substratschicht über die Bondingschicht an eine erste Substratschicht, die aus Nicht-Silikonharz gefertigt ist, und eine zweite Substratschicht, die aus Nicht-Silikonharz gefertigt ist, gebondet sind.

3. Mikrochip nach Anspruch 2,
wobei die erste Substratschicht, die aus Nicht-Silikonharz gefertigt ist, die gerillte Substratschicht ist, und die aus Polydimethylsiloxan gefertigte Substratschicht die dritte Substratschicht ist,
wobei die zweite Substratschicht, die aus Nicht-Silikonharz gefertigt ist, und die aus Polydimethylsiloxan gefertigte Substratschicht über die Bondingschicht, die aus einer organischen Siliciumverbindung gefertigt ist, gebondet sind,
wobei die zweite Substratschicht, die aus Nicht-Silikonharz gefertigt ist, keine Rille auf einer Bondingfläche aufweist, die an die aus Polydimethylsiloxan gefertigte Substratschicht gebondet ist.

4. Mikrochip nach Anspruch 3, wobei die aus Polydimethylsiloxan gefertigte Substratschicht über eine Bondingschicht, die aus einer anorganischen Siliciumverbindung gefertigt ist, an die erste Substratschicht gebondet ist, die aus Nicht-Silikonharz gefertigt ist.

5. Mikrochip nach Anspruch 2,
wobei die aus Polydimethylsiloxan gefertigte Substratschicht die gerillte Substratschicht ist,
und die erste Substratschicht, die aus Nicht-Silikonharz gefertigt ist, die dritte Substratschicht ist,
wobei die erste Substratschicht, die aus Nicht-Silikonharz gefertigt ist, und die zweite Substratschicht, die aus Nicht-Silikonharz gefertigt ist, jeweils über die Bondingschicht, die aus einer organischen Siliciumverbindung gefertigt ist, an die aus Polydimethylsiloxan gefertigte Substratschicht gebondet sind.

6. Mikrochip nach Anspruch 4, wobei die erste Substratschicht, die aus Nicht-Silikonharz gefertigt ist, und die zweite Substratschicht, die aus Nicht-Silikonharz gefertigt ist, aus Acrylharz oder Polycarbonat zusammengesetzt sind.

7. Mikrochip nach Anspruch 6, wobei die erste Substratschicht, die aus Nicht-Silikonharz gefertigt ist, und die zweite Substratschicht, die aus Nicht-Silikonharz gefertigt ist, gasundurchlässig sind.

8. Mikrochip nach Anspruch 7,
wobei die aus Polydimethylsiloxan gefertigte Substratschicht aufgrund von elastischer Verformung eine Selbstheilungsfähigkeit aufweist, wobei der versiegelte innere Raum relativ zu atmosphärischem Druck bei einem Unterdruck ist.

9. Verfahren zur Herstellung eines Mikrochips (1c), wobei das Verfahren umfasst:
Bilden einer Vielzahl von Substratschichten (11, 12, 13), und
Laminieren einer Vielzahl von Bondingschichten (22a) an Grenzflächen zwischen den Substratschichten, wobei die Bondingschichten eine Siliciumverbindung einschließen und mindestens eine der Bondingschichten eine organische Siliciumverbindung einschließt;
Bilden einer oberen Substratschicht (13) von der Vielzahl von Substratschichten, um eine Öffnung (31) darin einzuschließen, um zuzulassen, dass ein Anteil eines Durchstichelements in den Mikrochip eindringt; und
Bilden einer gerillten Substratschicht (11) von der Vielzahl der Substratschichten mit einer Rillenbildungsfläche, auf der eine Rille gebildet ist, und
Bilden einer dritten Substratschicht (12) von der Vielzahl von Schichten, um an die Rillenbildungsfläche der gerillten Substratschicht gebondet zu werden, wodurch ein versiegelter Bereich (43, 53) gebildet wird.

10. Verfahren zur Herstellung eines Mikrochips gemäß Anspruch 9, wobei das Verfahren umfasst:
einen Abscheideprozess des Beschichtens der Rillenbildungsfläche der gerillten Substratschicht, die aus Nicht-Silikonharz gefertigt ist, mit einer vernetzbaren Zusammensetzung, die eine Siliciumverbindung enthält; und
einen Beschichtungsprozess des Beschichtens einer Oberfläche der oberen Substratschicht, die aus Nicht-Silikonharz gefertigt ist, mit einer vernetzbaren Zusammensetzung, die eine organische Siliciumverbindung enthält, wobei die Oberfläche der oberen Substratschicht ohne Rille bereitgestellt wird.

11. Verfahren zur Herstellung eines Mikrochips gemäß Anspruch 10, wobei das Verfahren umfasst:
einen Bondingprozess des Bondens von jeder von der Rillenbildungsfläche der gerillten Substratschicht, die aus Nicht-Silikonharz gefertigt ist, und der Oberfläche der oberen Substratschicht, die aus Nicht-Silikonharz gefertigt ist, an eine dritte Substratschicht, die aus Polydimethylsiloxan gefertigt ist, wobei die Rillenbildungsfläche der gerillten Substratschicht mit der vernetzbaren Zusammensetzung beschichtet ist, die eine Siliciumverbindung enthält, wobei die Oberfläche der oberen Substratschicht mit der vernetzbaren Zusammensetzung beschichtet ist, die die organische Siliciumverbindung enthält, und ohne Rille bereitgestellt wird.

## Revendications

1. Micropuce (1c) comprenant :
une pluralité de couches de substrat (11, 12, 13) ; et
des couches de liaison (22a) appliquées sur des surfaces frontières entre les couches de substrat et qui comportent un composé de silicium,
dans laquelle au moins une des couches de liaison comporte un composé de silicium organique,
dans laquelle la pluralité de couches de substrat comporte une couche de substrat supérieure (13) ayant une ouverture formée à l'intérieur (31) pour permettre à une partie d'un élément de perforation de pénétrer dans la micropuce, une couche de substrat rainurée (11) ayant une rainure formée sur une surface de liaison, et une troisième couche de substrat (12) liée à la surface de liaison ayant la rainure, formant ainsi un espace interne scellé (43, 53).

2. Micropuce selon la revendication 1,
dans laquelle la pluralité de couches de substrat comporte une couche de substrat constituée de résine non siliconée et une couche de substrat constituée de polydiméthylsiloxane, et
dans laquelle les deux surfaces de la couche de substrat constituée de polydiméthylsiloxane sont liées à une première couche de substrat constituée de résine non siliconée et une deuxième couche de substrat constituée de résine non siliconée par la couche de liaison.

3. Micropuce selon la revendication 2,
dans laquelle la première couche de substrat constituée de résine non siliconée est la couche de substrat rainurée et la couche de substrat constituée de polydiméthylsiloxane est la troisième couche de substrat,
dans laquelle la deuxième couche de substrat constituée de résine non siliconée et la couche de substrat constituée de polydiméthylsiloxane sont liées par la couche de liaison constituée d'un composé de silicium organique, la deuxième couche de substrat constituée de résine non siliconée n'a aucune rainure sur une surface de liaison liée à la couche de substrat constituée de polydiméthylsiloxane.

4. Micropuce selon la revendication 3, dans laquelle la couche de substrat constituée de polydiméthylsiloxane est liée à la première couche de substrat constituée de résine non siliconée par une couche de liaison constituée d'un composé de silicium inorganique.

5. Micropuce selon la revendication 2,
dans laquelle la couche de substrat constituée de polydiméthylsiloxane est la couche de substrat rainurée et la première couche de substrat constituée de résine non siliconée est la troisième couche de substrat,
dans laquelle la première couche de substrat constituée de résine non siliconée et la deuxième couche de substrat constituée de résine non siliconée sont chacune liées à la couche de substrat constituée de polydiméthylsiloxane par la couche de liaison constituée d'un composé de silicium organique.

6. Micropuce selon la revendication 4, dans laquelle la première couche de substrat constituée de résine non siliconée et la deuxième couche de substrat constituée de résine non siliconée sont composées de résine acrylique ou de polycarbonate.

7. Micropuce selon la revendication 6, dans laquelle la première couche de substrat constituée de résine non siliconée et la deuxième couche de substrat constituée de résine non siliconée sont imperméables aux gaz.

8. Micropuce selon la revendication 7,
dans laquelle la couche de substrat constituée de polydiméthylsiloxane a une capacité d'auto-scellement due à une déformation élastique,
dans laquelle l'espace interne scellé est à une pression négative par rapport à la pression atmosphérique.

9. Procédé de fabrication d'une micropuce (1c), le procédé comprenant :
la formation d'une pluralité de couches de substrat (11, 12, 13) ;
l'application d'une pluralité de couches de liaison (22a) à des surfaces frontières entre les couches de substrat, les couches de liaison comportant un composé de silicium et au moins une des couches de liaison comportant un composé de silicium organique ;
la formation d'une couche de substrat supérieure (13) de la pluralité de couches de liaison pour qu'elle renferme une ouverture (31) pour permettre à une partie d'un élément de perforation de pénétrer dans la micropuce ; et
la formation d'une couche de substrat rainurée (11) de la pluralité de couches de liaison avec une surface de formation de rainure sur laquelle une rainurée est formée, et
la formation d'une troisième couche de substrat (12) de la pluralité de couches de liaison pour qu'elle soit liée à la surface de formation de rainure sur la couche de substrat rainurée, formant ainsi une zone scellée (43, 53).

10. Procédé de fabrication d'une micropuce selon la revendication 9, le procédé comprenant :
un procédé de dépôt consistant à recouvrir la surface de formation de rainure de la couche de substrat rainurée constituée de résine non siliconée avec une composition réticulable contenant un composé de silicium ; et
un procédé de revêtement consistant à recouvrir une surface de la couche de substrat supérieure constituée de résine non siliconée avec une composition réticulable contenant un composé de silicium organique, la surface de la couche de substrat supérieure n'étant pourvue d'aucune rainure.

11. Procédé de fabrication d'une micropuce selon la revendication 10, le procédé comprenant :
un procédé de liaison consistant à lier à la fois la surface de formation de rainure de la couche de substrat rainurée constituée de résine non siliconée et la surface de la couche de substrat supérieure constituée de résine non siliconée à une troisième couche de substrat constituée de polydiméthylsiloxane, la surface de formation de rainure de la couche de substrat rainurée étant recouverte par la composition réticulable contenant un composé de silicium, la surface de la couche de substrat supérieure étant recouverte par la composition réticulable contenant un composé de silicium organique et n'étant pourvue d'aucune rainure.
